# EUROPÄISCHE PATENTSCHRIFT

(11) **EP 3 346 545 B1**
(45) Veröffentlichungstag und Bekanntmachung des Hinweises auf die Patenterteilung: **20.04.2022**
(21) Anmeldenummer: 18150225.3
(22) Anmeldetag: 03.01.2018
(51) Int. Cl.: H01Q 1/22, H01Q 1/44, H01Q 9/42, H01Q 19/10

(54) **BÄNDCHENBONDANTENNEN**
STRIP BOND ANTENNAS
ANTENNES DE LIAISON À RUBAN

(30) Priorität: 05.01.2017 DE 102017200130
(43) Veröffentlichungstag der Anmeldung: 11.07.2018
(73) Patentinhaber: Fraunhofer-Gesellschaft zur Förderung der angewandten Forschung e.V., 80686 München (DE)
(72) Erfinder: Ndip, Ivan, 13469 Berlin (DE)
(74) Vertreter: Hersina, Günter

(56) Entgegenhaltungen:
- WO-A1-00/65691
- WO-A1-2014/049088
- WO-A1-2014/088210
- US-A1- 2006 028 378
- US-A1- 2007 170 560
- US-A1- 2014 138 446

## Beschreibung

Die vorliegende Erfindung bezieht sich auf Antennenvorrichtungen mit Bändchen (engl.: Ribbons). Die vorliegende Erfindung bezieht sich ferner auf Bändchenbondantennen (engl.: Ribbon Bond Antennas - RBAs).

Bei höheren Frequenzen, wie etwa im Millimeter-Wellenlängenbereich und höher leidet die Abstrahleffizienz planarer Antennen wie Patch-Antennen, Dipolantennen, Monopolantennen etc. stark unter Verlusten im Zusammenhang mit Dielektrika, die mit der Herstellung von Antennen verwendet werden. Hierzu gehören dielektrische Verluste und Oberflächenwellenverluste.

Darüber hinaus verursacht die Verschaltung zwischen dem Hochfrequenz-Chip (HF) und einer Antenne auf dem Interposer oder der Platine Probleme mit der Signalintegrität, was die Systemleistung beeinflusst.

In US 2014/0138446 A1 ist eine RFID Anordnung beschrieben, bei der Drähte auf einem receiving layer angeordnet werden.

In WO 2014/049088 A1 ist eine Vorrichtung beschreiben, bei der ein Layer aus Epoxy angeordnet wird. Dieser bedeckt die gesamte Vorrichtung.

In WO 00/65691 ist eine Mikrowellenlinse beschreiben. Ein droplet wird über einer Anordnung inklusive Mikrowellenchip angeordnet.

In WO 2014/088210 A1 ist eine Vorrichtung beschrieben, bei der Antennen durch bond wires erhalten werden, die direkt mit dem Chip verbunden werden.

In US 2006/0028378 A1 ist eine Vorrichtung beschrieben, bei der Antennen durch bond wires erhalten werden, die direkt mit dem Chip verbunden werden.

In US 2007/0170560 A1 ist eine Vorrichtung beschrieben, bei der bond wires in dem Gehäuse angeordnet sind, dabei jedoch in dem Chip-Gehäuse sind. Die aus dem Gehäuse ragenden Beine werden als Antenne verwendet.

Wünschenswert wären demnach Möglichkeiten, Signale mit einer hohen Effizienz abzustrahlen.

Eine Aufgabe der vorliegenden Erfindung besteht deshalb darin, Konzepte zu schaffen, mit denen ein Funksignal mit hoher Effizienz abgestrahlt werden kann und die auch im Hochfrequenzbereich einsetzbar sind.

Diese Aufgabe wird durch den Gegenstand der unabhängigen Patentansprüche gelöst.

Die Erfindung umfasst eine Antennenvorrichtung ein Substrat mit einer ersten Hauptseite und einer gegenüberliegend angeordneten zweiten Hauptseite. Die Antennenvorrichtung umfasst einen ersten Befestigungsbereich und einen zweiten Befestigungsbereich, die an der ersten Hauptseite angeordnet sind. Die Antennenvorrichtung umfasst ferner ein den ersten Befestigungsbereich und den zweiten Befestigungsbereich verbindendes Bändchen, das zumindest bereichsweise von dem Substrat beabstandet ist. Die Antennenvorrichtung umfasst eine an der zweiten Hauptseite angeordnete Metallisierung, die gegenüberliegend zumindest einem aus dem ersten Befestigungsbereich, dem zweiten Befestigungsbereich und dem Bändchen angeordnet ist. Dies ermöglicht eine effiziente Abstrahlung eines Funksignals über das Bändchen. Die zumindest bereichsweise Beabstandung des Bändchens von dem Substrat ermöglicht eine Reduzierung oder Vermeidung von Überflächenwellenverlusten und/oder eine Reduzierung dielektrischer Verluste. Gleichzeitig kann mit der Metallisierung an der zweiten Hauptseite ein Rückstrompfad der Antennenvorrichtung realisiert werden.

Erfindungsgemäß ist die Antennenvorrichtung ausgebildet, um ansprechend auf ein an den ersten Befestigungsbereich angelegtes elektrisches Signal ein Funksignal mit dem Bändchen auszusenden, wobei ein Wellenlängenbereich des Funksignals von einer Länge des Bändchens beeinflusst ist. Dies ermöglicht, dass eine Anordnung zusätzlicher expliziter Antennenstrukturen vermieden werden kann, das bedeutet, die Erzeugung des Funksignals erfolgt im Wesentlichen durch das Bändchen. Dies ermöglicht eine platzsparende Realisierung einer Antenne auf dem Substrat.

Gemäß einem weiteren Ausführungsbeispiel ist die Metallisierung an der zweiten Hauptseite gegenüberliegend dem ersten Befestigungsbereich, dem zweiten Befestigungsbereich und dem Bändchen angeordnet. Dies ermöglicht eine Abschirmung von Komponenten, die auf einer dem Bändchen abgewandten Seite der Metallisierung angeordnet sind bezüglich eines Funksignals, das mit der Antennenvorrichtung erzeugt wird, so dass gute Eigenschaften bezüglich der elektromagnetischen Verträglichkeit erhalten werden. Gemäß einem weiteren Ausführungsbeispiel ist die an der zweiten Hauptseite angeordnete Metallisierung ein Reflektor für ein durch das Bändchen ausgesendetes Funksignal. Dies ermöglicht eine hohe Effizienz der Abstrahlung der Antennenvorrichtung.

Gemäß einem weiteren Ausführungsbeispiel ist der zweite Befestigungsbereich und die an der zweiten Hauptseite angeordnete Metallisierung durch eine elektrisch leitfähige Struktur, etwa ein Via, durch ein Substratmaterial des Substrats hindurch verbunden. Dies ermöglicht die Nutzung der Metallisierung als galvanisch verbundenen Rückstrompfad.

Erfindungsgemäß ist ein Wellenlängenbereich eines mit dem Bändchen und der leitfähigen Struktur ausgesendeten Funksignals durch eine Summe einer Länge des Bändchens und einer Länge der leitfähigen Struktur beeinflusst. Dies ermöglicht eine gegenseitige Justierung und Anpassung der Länge der leitfähigen Struktur und der Länge des Bändchens, um das Funksignal in einem gewünschten Wellenlängenbereich auszusenden.

Gemäß einem weiteren Ausführungsbeispiel ist der zweite Befestigungsbereich so ausgebildet, dass er den ersten Befestigungsbereich zumindest teilweise umschließt, so dass der erste Befestigungsbereich bezüglich des zweiten Befestigungsbereichs als coplanare Versorgungsleitung wirkt. Dies ermöglicht ein geringes Ausmaß an parasitären Abstrahlungen, eine gute Störabstrahleigenschaft und eine hohes Maß an elektromagnetischer Verträglichkeit (EMV).

Gemäß einem weiteren Ausführungsbeispiel umfasst die Antennenvorrichtung ein Gehäuse, in welchem die Antennenvorrichtung angeordnet ist. Die Antennenvorrichtung weist einen Anschluss zum Verbinden der Antennenvorrichtung mit einem Hochfrequenz-Chip auf. Dies ermöglicht die komponentenweise Bereitstellung von Antennenvorrichtungen, um diese erst später mit einem Hochfrequenz-Chip in Verbindung zu bringen.

Weitere Ausführungsbeispiele schaffen ein Antennenarray mit zumindest einer ersten und einer zweiten Antennenvorrichtung. Die Antennenvorrichtungen können seriell miteinander verbunden sein, um einen Wellenlängenbereich eines mit dem Antennenarray ausgesendeten Funksignals durch eine Summe einer Länge der Leiterbänder der ersten Antennenvorrichtung und der zweiten Antennenvorrichtung zu beeinflussen oder können galvanisch getrennt voneinander sein und dabei so angeordnet sein, dass die zweite Antennenvorrichtung bezüglich der ersten Antennenvorrichtung als Reflektor-Antenne oder als Direktor-Antenne wirkt.

Weitere Ausführungsbeispiele beziehen sich auf eine elektrische Schaltung mit einer Antennenvorrichtung gemäß Ausführungsbeispielen und einem Hochfrequenz-Chip, der ausgebildet ist, um ein Hochfrequenzsignal an einem Signalausgang bereitzustellen und der auf dem Substrat der Antennenvorrichtung angeordnet ist. Der erste Befestigungsbereich ist mit dem Signalausgang elektrisch verbunden. Dies ermöglicht die direkte Abstrahlung eines Hochfrequenzsignals des Hochfrequenz-Chips mit dem Bändchen, so dass das Erfordernis zusätzlicher Antennenstrukturen vermieden werden kann.

Weitere Ausführungsbeispiele sind der Gegenstand weiterer abhängiger Patentansprüche.

Bevorzugte Ausführungsbeispiele der vorliegenden Erfindung werden nachfolgend Bezug nehmend auf die beiliegenden Zeichnungen erläutert. Es zeigen:
- Fig. 1: eine schematische Seitenschnittansicht einer Antennenvorrichtung gemäß einem Ausführungsbeispiel;
- Fig. 2a: eine schematische perspektivische Ansicht einer Antennenvorrichtung gemäß einem weiteren Ausführungsbeispiel, bei der ein zweiter Befestigungsbereich so ausgeführt ist, dass er einen ersten Befestigungsbereich zumindest teilweise umschließt;
- Fig. 2b: eine schematische Seitenschnittansicht der Antennenvorrichtung aus Fig. 2a;
- Fig. 2c: Fig. 2c zeigt eine schematische Aufsicht einer Antennenvorrichtung 20 gemäß einem Ausführungsbeispiel, bei der das Bändchen segmentweise diskontinuierlich gekrümmt ist;
- Fig. 3: eine schematische perspektivische Ansicht einer Antennenvorrichtung gemäß einem weiteren Ausführungsbeispiel, bei der eine rückseitige Metallisierung gegenüberliegend einem Bändchen der Antennenvorrichtung angeordnet ist;
- Fig. 4a: eine schematische Seitenschnittansicht einer Antennenvorrichtung gemäß einem weiteren Ausführungsbeispiel, bei der der zweite Befestigungsbereich und die Metallisierung durch eine elektrisch leitfähige Struktur verbunden sind;
- Fig. 4b: eine schematische Aufsicht auf die Antennenvorrichtung aus Fig. 4a;
- Fig. 5a: eine schematische Seitenschnittansicht einer Antennenvorrichtung gemäß einem Ausführungsbeispiel, die ein Gehäuse aufweist;
- Fig. 5b: eine schematische Seitenschnittansicht einer Antennenvorrichtung gemäß einem Ausführungsbeispiel, die das Gehäuse aufweist und bei der die Metallisierung mit einer Wand des Gehäuses verbunden ist oder die Wand bildet;
- Fig. 5c: eine schematische Seitenschnittansicht einer Antennenvorrichtung gemäß einem Ausführungsbeispiel, bei der das Gehäuse als Linse ausgeführt ist;
- Fig. 6a: eine schematische Aufsicht auf ein weiteres Antennenarray gemäß einem Ausführungsbeispiel;
- Fig. 6b: eine schematische Aufsicht auf ein Antennenarray gemäß einem Ausführungsbeispiel, das als Yagi-Uda-Antenne ausgeführt ist.;
- Fig. 7: eine schematische Aufsicht auf eine elektrische Schaltung gemäß einem weiteren Ausführungsbeispielbei der der Signalausgang eines Hochfrequenz-Chips gleichzeitig als Befestigungsbereich nutzbar ist;
- Fig. 8a: ein schematisches Blockschaltbild eines Antennenarray, das eine erste Antennenvorrichtung und eine zweite Antennenvorrichtung umfasst, die parallel zueinander geschaltet sind; und
- Fig. 8b: eine schematische Ansicht eines Antennenarrays gemäß einem weiteren Ausführungsbeispiel, das vier Antennenvorrichtungen umfasst, die über ein Netzwerk von Spannungs- oder Leistungsteilern mit einer Versorgung verbunden sind.

Bevor nachfolgend Ausführungsbeispiele der vorliegenden Erfindung im Detail anhand der Zeichnungen näher erläutert werden, wird darauf hingewiesen, dass identische, funktionsgleiche oder gleichwirkende Elemente, Objekte und/oder Strukturen in den unterschiedlichen Figuren mit den gleichen Bezugszeichen versehen sind, so dass die in unterschiedlichen Ausführungsbeispielen dargestellte Beschreibung dieser Elemente untereinander austauschbar ist bzw. aufeinander angewendet werden kann.

Obwohl nachfolgende Ausführungsbeispiele so beschreiben sind, dass Antennenvorrichtungen zur Abstrahlung eines Funksignals nutzbar sind, versteht es sich, dass mit Antennenvorrichtungen auch Funksignale empfangbar sind. Ausführungsformen sind deshalb ohne Einschränkungen auf Empfangsantennen übertragbar.

Hierin beschriebene Ausführungsbeispiele beschreiben Antennenvorrichtungen, elektrische Schaltungen und Antennenarrays, bei denen ein Funksignal unter Verwendung eines oder mehrerer Bändchen erzeugt wird. Diese Bändchen werden in der englischen Sprache auch als Ribbons oder Robbonbonds bezeichnet. Die hierin beschriebenen Antennenvorrichtungen können als Ribbonbondantennen (RBA) bezeichnet werden.

Antennenvorrichtungen mit Ribbons können in Anlehnung an eine Schleifen- bzw. Halbschleifenantenne gebildet sein und als Quasi-Halbbschleifenantenne (Quasi-Half-Loop) bezeichnet werden. Eine derartige Antenne kann eine Spiegelebene umfassen, etwa eine Ebene, die zur Stromrückführung genutzt wird. Ist diese Ebene an einer der Antennenvorrichtung gegenüberliegenden Seite eines dielektrischen Substrats angeordnet, so kann auch der Begriff dielektrische Quasi-Halbschleifenantenne (Dielectric Quasi-Half-Loop) verwendet werden.

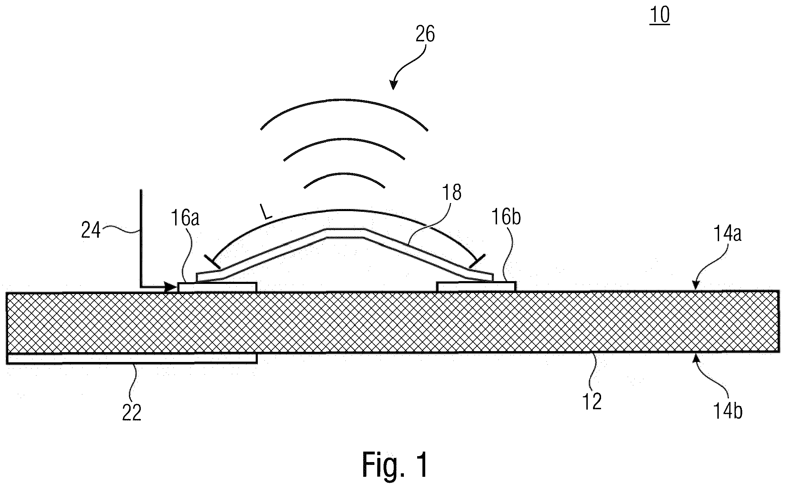

Fig. 1 zeigt eine schematische Seitenschnittansicht einer Antennenvorrichtung 10 gemäß einem Ausführungsbeispiel. Die Antennenvorrichtung 10 umfasst ein Substrat 12, das eine erste Hauptseite 14a und eine gegenüberliegend angeordnete Hauptseite 14b aufweist. Bei den Hauptseiten 14a und 14b handelt es sich beispielsweise um Seiten mit einer flächenmäßig größeren Ausdehnung verglichen mit einer oder mehreren Seitenflächen. Beispielsweise kann es sich bei einem plattenförmigen Substrat 12 um eine Oberseite und eine Unterseite handeln, wenn das Substrat 12 in einem stabilen Zustand auf einem Tisch oder dergleichen liegend angeordnet ist. Es versteht sich, dass die Begriffe Oberseite und Unterseite wechselseitig miteinander vertauschbar sind oder durch Begriffe wie laterale Seite substituierbar sind, wenn die Anordnung des Substrats 12 im Raum verändert wird. Deshalb sollen Begriffe wie oben, unten, links, rechts, vorne, hinten und dergleichen in hierin beschriebenen Ausführungsbeispielen nicht einschränkend verstanden werden, sondern lediglich der besseren Verständlichkeit dienen.

An der ersten Hauptseite 14a sind zumindest zwei Befestigungsbereiche 16a und 16b zum befestigen elektrischer Leiter angeordnet. Bei den Befestigungsbereichen 16a und/oder 16b kann es sich beispielsweise um Metallisierungen wie etwa Bondpads, Streifenleitungen oder dergleichen handeln, an denen weitere Strukturen mechanisch und/oder mit einer elektrischen Verbindung angeordnet werden können, etwas durch eine Klebe- oder Lötverbindung.

Die Antennenvorrichtung 10 umfasst ein Bändchen (engl.: Ribbon) 18, das die Befestigungsbereiche 16a und 16b elektrisch miteinander verbindet. Als alternativen jedoch synonymen Begriff kann ein Bändchen auch als Leiterband bezeichnet werden. Die Bändchen sind elektrisch leitfähige Strukturen, die zum Übertragen elektrischer Signale, Spannungen und/oder Ströme einsetzbar sind. Das bedeutet, dass die Befestigungsbereiche 16a und 16b durch das Bändchen 18 elektrisch miteinander verbunden sind. Das Bändchen 18 ist zumindest bereichsweise von dem Substrat 12 beabstandet. Hierfür kann das Bändchen 18 beispielsweise als eine Brückenstruktur oder eine Bogenstruktur zwischen den Befestigungsbereichen 16a und 16b angeordnet sein. Das Bändchen 18 kann in direktem mechanischen Kontakt zu den Befestigungsbereichen 16a und/oder 16b stehen und beispielsweise dort nicht von dem Substrat 12 beabstandet sein. So können beispielsweise die Befestigungsbereiche 16a und/oder 16b in eine Oberfläche des Substrats 12 integriert sein. Alternativ hierzu kann zumindest einer der Befestigungsbereiche 16a oder 16b bereits einen Abstand von dem Substrat 12 bereitstellen. Alternativ oder zusätzlich kann auch eine die mechanische Verbindung bereitstellende und beibehaltende mechanische Struktur zu einer Beabstandung zwischen den Befestigungsbereiche 16a und/oder 16b führen, etwa ein Lotmaterial, das zwischen dem Bändchen 18 und zumindest einem der Befestigungsbereiche 16a oder 16b angeordnet ist, so dass das Bändchen 18 auch vollständig von dem Substrat 12 beabstandet sein kann. Die zumindest teilweise oder bereichsweise Beabstandung des Bändchens von dem Substrat ermöglicht eine Reduzierung oder Vermeidung von Überflächenwellenverlusten und/oder eine Reduzierung dielektrischer Verluste. Ferner kann eine räumliche 3D-Abstrahlung erhalten werden.

Die Antennenvorrichtung 10 umfasst ferner eine Metallisierung 22, die an der zweiten Hauptseite 14b angeordnet ist. Die Metallisierung 22 kann ein beliebiges elektrisch leitfähiges Metallmaterial, etwa Kupfer, Gold, Aluminium oder dergleichen oder eine Kombination umfassend zumindest ein Metallmaterial umfassen. Die Metallisierung 22 kann als zumindest bereichsweise an der Hauptseite 14b gebildete Schicht ausgeführt sein. Das bedeutet, die Metallisierung 22 kann, muss aber nicht die gesamte zweite Hauptseite 14b bedecken. Andere Teile der zweiten Hauptseite 14b des Substrats 12 können von der Metallisierung 22 unbedeckt bleiben. Die Metallisierung 22 ist gegenüberliegend dem Befestigungsbereich 16a und/oder gegenüberliegend dem Befestigungsbereich 16b und/oder gegenüberliegend zumindest eines Abschnitts des Bändchens 18 oder des gesamten Bändchens 18 gebildet, d. h., angeordnet. Als gegenüberliegend kann zwar eine Anordnung der Metallisierung 22 entlang der Oberflächennormalen des Substrats 12 am Ort des Befestigungsbereichs 16a und/oder 16b oder des Bändchens 18 verstanden werden. Alternativ hierzu genügt auch eine Anordnung der Metallisierung 22 derart, dass von den genannten Komponenten ausgesendete elektromagnetische Felder, etwa Funkwellen, mit der Metallisierung 22 wechselwirken, etwa als Reflektor oder Rückstrompfad, dem Erfordernis der gegenüberliegenden Anordnung.

An den Befestigungsbereich 16a oder den Befestigungsbereich 16b kann ein elektrisches Signal 24 anlegbar sein. Bei dem elektrischen Signal 24 kann es sich beispielsweise um ein Hochfrequenzsignal handeln. Als hochfrequent wird im Zusammenhang mit hierin beschriebenen Ausführungsbeispielen insbesondere ein Signal verstanden, das eine Frequenz von zumindest 150 kHz aufweist. Das elektrische Signal 24 weist bevorzugt eine Frequenz von zumindest 1 MHz auf und ist besonders bevorzugt zur Erzeugung von sogenannten Mikrowellen/Millimeter-Wellen nutzbar, etwa eine Frequenz in einem Frequenzband von zumindest 30 GHz bis höchstens 300 GHz aufweisend, bevorzugt zwischen 30 GHz und 80 GHz, oder weiter bevorzugt zwischen 60 GHz und 80 GHz. Andere Frequenzbereiche, z. B. Terahertzbereiche sind ebenfalls realisierbar. Als Millimeter-Wellen werden Wellenlängen in einem Bereich von zumindest 1 mm und höchstens 10 mm verstanden, die über den Zusammenhang A = c/f mit einer Frequenz des elektrischen Signals 24 korrespondieren.

Die Antennenvorrichtung 10 ist ausgebildet, um ein Funksignal 26 aus zusenden, das auf dem elektrischen Signal 24 basiert. Dies kann beispielsweise durch einen Empfang des elektrischen Signals 24 an dem Befestigungsbereich 16a, die Übertragung des elektrischen Signals 24 an den Befestigungsbereich 16b bei gleichzeitiger Erzeugung des Funksignals 26 sowie einer Wirkung der Metallisierung 22 als Rückpfad erhalten werden.

Eine Auslegung der Länge L des Bändchens 18 kann beispielsweise in einem Zusammenhang von ca. L = λ/8, λ/4, λ/2, λ, 2λ, 4λ oder dergleichen erfolgen, wobei λ eine Wellenlänge des Funksignals 26 ist. Bevorzugt ist die Antennenvorrichtung 10 als λ/2-Strahler oder als λ/4-Strahler ausgeführt. Bezüglich des Zusammenhangs zwischen der Wellenlänge λ und der Gesamtlänge L_{ges} kann jeweils ein Toleranzbereich von höchstens 70 %, höchstens 50 % oder höchstens 30 % anwendbar sein. Insbesondere im Millimeter-Wellenlängenbereich kann jedoch eine exakte Auslegung der Länge L des Bändchens 18 an ein von der Antennenvorrichtung 10 bereitzustellendes Frequenzband des Funksignals 26 vorteilhaft sein, so dass ein Toleranzbereich von höchstens 30 %, höchstens 20 % oder höchstens 10 % anwendbar sein kann.

Obwohl die Metallisierung 22 so dargestellt ist, dass sie gegenüberliegend dem Befestigungsbereich 16a angeordnet ist, kann sie alternativ oder zusätzlich gegenüberliegend dem Bändchens 18 und/oder dem Befestigungsbereich 16b angeordnet sein, um eine elektromagnetische Einkopplung des Funksignals 26 in die Metallisierung 22 zu ermöglichen. Durch die elektromagnetische Einkopplung in die Metallisierung 22 kann ein Rückstrompfad bezüglich des elektrischen Signals 24 erhalten werden.

Die Antennenvorrichtung 10 stellt eine Bändchen- bzw. Bändchenbond-Antenne dar, das bedeutet, die Antennenfunktion wird von (Leitungs-)Bändchen, wie sie zum Bonden von Bauteilen verwendet werden können, zumindest teilweise implementiert. Das Bändchen 18 kann auch als Ribbon Bond bezeichnet werden. Bei der Antennenvorrichtung 10 kann es sich um eine Ribbon Bond Antenne (RBA) handeln. Die RBA kann in beliebiger Weise gespeist, das heißt mit dem elektrischen Signal 24 versorgt werden. Hierzu kann beispielsweise der Befestigungsbereich 16a oder der Befestigungsbereich 16b coplanar mit dem elektrischen Signal versorgt werden. Alternativ oder zusätzlich kann einer der Befestigungsbereiche 16a und/oder 16b mit einer Streifenleitung (engl.: Microstrip) verbunden werden, um das elektrische Signal 24 zu erhalten. Alternativ oder zusätzlich kann das elektrische Signal 24 mittels elektromagnetischer Kopplung etwas durch eine sogenannte Aperturkopplung (engl.: Aperture Feed) oder durch eine Nahfeldspeisung (engl.: Proximity Feed) und/oder durch eine vertikale Kontaktierung gespeist werden, etwa unter Nutzung eines Vias. Die Antennenvorrichtung 10 kann einen Anschluss zur vertikalen Speisung oder zur horizontalen Speisung umfassen. Über den Anschluss kann das elektrische Signal 24 empfangen werden ein Funksignal 26 bereitzustellen. Die Kopplung des Signals 24 an die Antenne kann vertikal, etwa über eine Proximity Feed, eine Aperture-coupled Feed eine Probe feed oder dergleichen erfolgen. Alternativ kann die Antennenvorrichtung auch horizontal über Leitungen angeregt werden. Das bedeutet, dass obwohl in der Fig. 1 dargestellt ist, dass das elektrische Signal an den Befestigungsbereich 16a geführt wird, das elektrische Signal 24 auch an den Befestigungsbereich 16b geführt werden kann, um die Antennenvorrichtung 10 zu speisen.

Zwar könnte das Funksignal 26 auch mittels eines Bonddrahtes erzeugt werden. Wie Leiterbänder können auch Bonddrähte als emittierende Antenne die Vermeidung einer Anordnung einer zusätzlichen Antenne auf dem Interposer oder der Platine ermöglichen. Sie können gleichzeitig für das Verbinden einer Chipanordnung und als Antenne verwendet werden. Gegenüber einer Verwendung von Bonddrähten weisen Leiterbänder jedoch weitere Vorteile auf, wie etwa eine höhere Unempfindlichkeit gegenüber Prozessparametern und Prozessveränderungen, das bedeutet, dass Leiterbänder mit einer höheren Präzision hergestellt und angeordnet werden können. Ferner weist die Struktur des Bändchens gegenüber der Struktur eines Drahtes eine höhere Stabilität auf. Leiterbänder haben ferner eine hohe Abstrahlungseffizienz, da sie geringere Metallisierungsverluste als Bonddrähte aufweisen. Deshalb können sie mit einer besseren Abstrahlungsleistung betrieben werden, die jene von Bonddrähten oder Bond Wire Antennas (BWA) übertrifft. Diese Vorteile werden unter anderem dadurch erhalten, dass das Bändchen 18 gegenüber einem in etwa rotationssymmetrischen Bonddraht eine veränderte Geometrie aufweist. Eine axiale Erstreckung entlang der Länge L, eine laterale Abmessung, etwa als Breite bezeichnet, senkrecht hierzu sowie eine Höhen- oder Dickenausdehnung senkrecht zu der axialen und lateralen Erstreckung können unterschiedliche Aspektverhältnisse aufweisen. Gegenüber zylindrisch ausgebildeten Bonddrähten können Bändchen flach ausgebildet sein. Die Länge L des Bändchens 18 kann einen beliebigen Wert aufweisen und im Zusammenhang mit obigen Werten des abzustrahlenden oder zu empfangenden Frequenzbereichs dimensioniert werden.

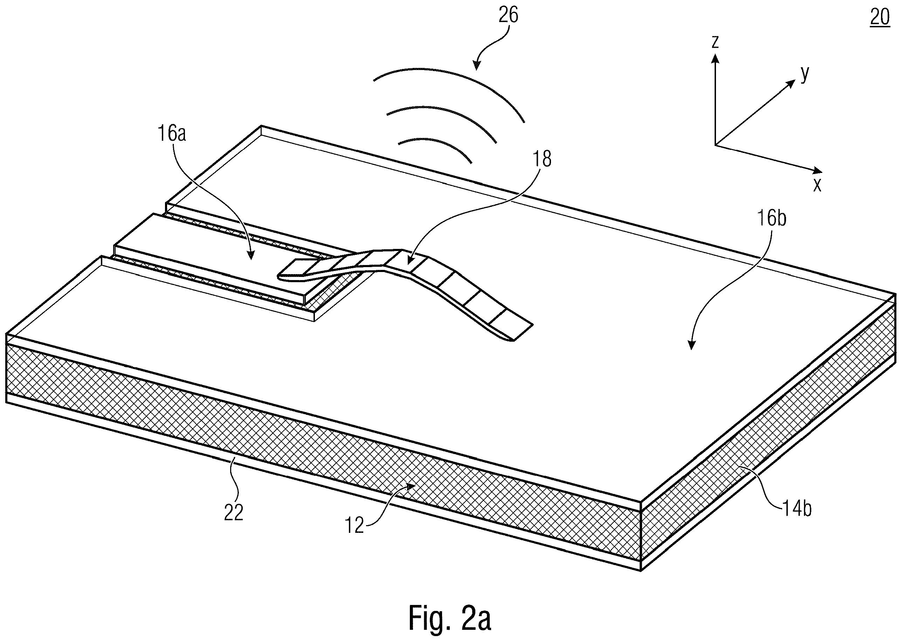

Fig. 2a zeigt eine schematische perspektivische Ansicht einer Antennenvorrichtung 20 gemäß einem weiteren Ausführungsbeispiel. Verglichen mit der Antennenvorrichtung 10 ist der Befestigungsbereich 16b so ausgeführt, dass er den Befestigungsbereich 16a zumindest teilweise umschließt. Dies ermöglicht, dass der Befestigungsbereich 16b und der Befestigungsbereich 16a eine coplanare Anordnung aus Versorgungshin- und Versorgungsrückleitung bilden. Bevorzugt umschließt der Befestigungsbereich 16b den Befestigungsbereich 16a an zumindest zwei oder zumindest drei Seiten der planaren Anordnung. Besonders bevorzugt ist der Befestigungsbereich 16a höchstens an einer Seite nicht von dem Befestigungsbereich 16b umschlossen, wobei sich die Anzahl der Seiten auf Richtungen in einer Ebene beziehen, in der die Befestigungsbereiche 16a und 16b angeordnet sind. Beispielsweise kann zumindest eine der Hauptseiten des Substrats 12 parallel zu einer x/y-Ebene angeordnet sein, während sich das Bändchen 18 senkrecht hierzu entlang einer z-Richtung eines kartesischen Koordinatensystems zumindest bereichsweise vom Substrat 12 abhebt, das heißt beabstandet ist. Die Seiten, an denen der Befestigungsbereich 16a von dem Befestigungsbereich 16b umschlossen ist, können beispielsweise jeweils positive und/oder negative x-Richtungen und/oder y-Richtungen sein. Eine Anordnung als coplanare Versorgungsleitungen der Befestigungsbereiche 16a und 16b ermöglicht ein hohes Maß an Abschirmung gegenüber benachbarten Schaltungskomponenten.

Unabhängig hiervon kann die Metallisierung 22 flächig ausgeführt sein und beispielsweise gegenüberliegend den Befestigungsbereichen 16a, 16b und dem Bändchen 18 angeordnet sein. Basierend auf der flächigen Ausbildung des Befestigungsbereichs 16b kann die Metallisierung 22 sich ebenfalls über die gesamte Fläche des Substrats 12 erstrecken. Ist beispielsweise der Befestigungsbereich 16b mit einer geringen Flächenausdehnung ausgebildet, wie es beispielsweise im Zusammenhang mit der Antennenvorrichtung 10 beschrieben ist, so kann auch die Metallisierung 22 eine geringe Flächenausdehnung aufweisen. Eine Anordnung der Metallisierung 22 gegenüberliegend der an der Abstrahlung beteiligten Komponenten, das heißt gegenüberliegend der Befestigungsbereiche 16a und 16b sowie des Bändchens 18 ermöglicht die Implementierung eines Reflektors. Die Wirkung der Metallisierung 22 als Reflektor ermöglicht eine hohe Abstrahleffizienz des Funksignals 26 in eine der Metallisierung 22 abgewandte Richtung des Substrats 12. Eine Anordnung der Metallisierung 22 gegenüberliegend mehreren Komponenten ermöglicht eine Abschirmung von weiteren Komponenten, die auf einer dem Bändchen abgewandten Seite der Metallisierung angeordnet sind bezüglich eines Funksignals, das mit der Antennenvorrichtung erzeugt wird, so dass gute Eigenschaften bezüglich der elektromagnetischen Verträglichkeit erhalten werden.

Alternativ zu einer flächigen und als Reflektor ausgeführten Metallisierung 22 ist es ebenfalls möglich, die Metallisierung 22 unterbrochen über die Hauptseite 14b des Substrats 12 hinweg auszuführen. So können unterbrechende Strukturen, etwa Aussparungen, genutzt werden, um Antennenstrukturen zu implementieren. So kann etwa eine schlitzförmige Aussparung in der Metallisierung 22 genutzt werden, um eine Schlitzantenne zu bilden, so dass das Funksignal auch in einer Richtung des Substrats 12, die dem Bändchen 18 abgewandt angeordnet ist.

In anderen Worten kann der Befestigungsbereich 16a als coplanare Speiseleitung bezeichnet werden. Die Metallisierung 22 kann als Reflektor oder Referenzpotential (engl.: Ground Plane) genutzt werden. Der Befestigungsbereich 16b kann als Rückleitung des Speisestroms, der durch das Bändchen 18 fließt, genutzt werden.

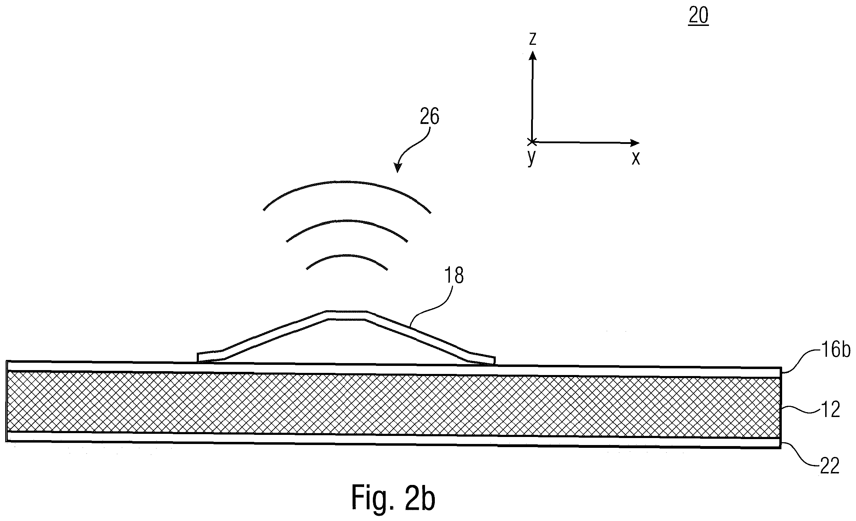

Fig. 2b zeigt eine schematische Seitenschnittansicht der Antennenvorrichtung 20. Durch die zumindest bereichsweise Beabstandung des Bändchens 18 von dem Substrat 12 kann eine dreidimensionale Abstrahlung des Funksignals 26 erhalten werden.

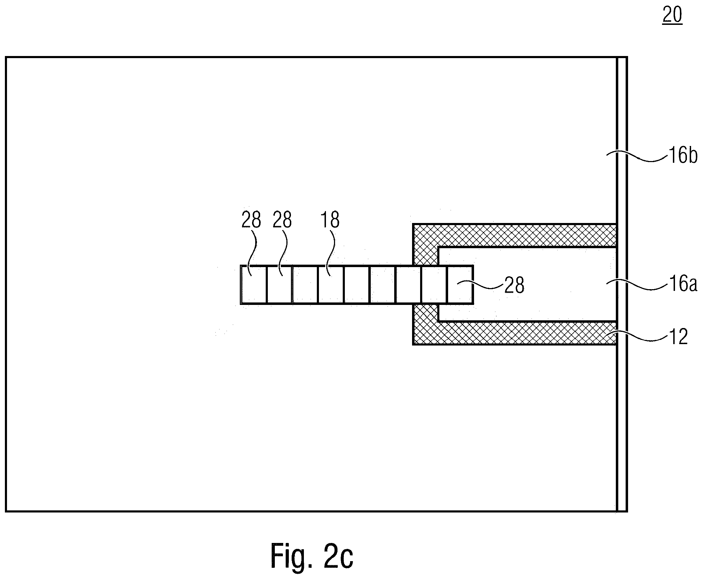

Fig. 2c zeigt eine schematische Aufsicht der Antennenvorrichtung 20. Das Leiterband 18 kann segmentweise in Segmenten 28 gekrümmt, das heißt diskontinuierlich gekrümmt oder gebogen sein. Alternativ hierzu kann das Leiterband 18 auch eine kontinuierliche Krümmung aufweisen.

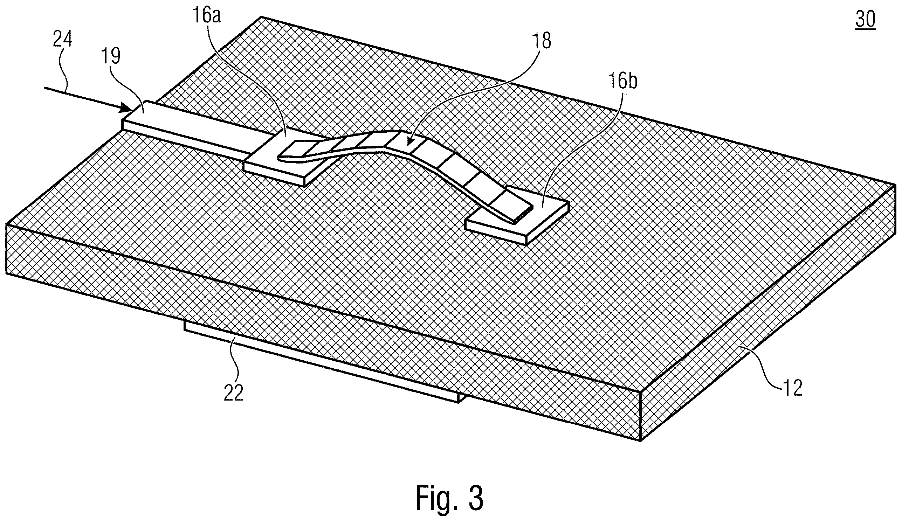

Fig. 3 zeigt eine schematische perspektivische Ansicht einer Antennenvorrichtung 30 gemäß einem weiteren Ausführungsbeispiel, bei der die Metallisierung 22 verglichen mit der Antennenvorrichtung 10 aus Fig. 1 gegenüberliegend dem Bändchen 18 angeordnet ist. In einer Mitte des Bändchens 18 ist zwischen der Metallisierung 22 und dem Bändchen lediglich das dielektrische Substrat 12 angeordnet. Ferner kann der Befestigungsbereich 16a mit einer Versorgungsleitung 19 verbunden sein. Die Versorgungsleitung 19 kann auf, an oder in dem Substrat 12 angeordnet sein und eine sogenannte horizontale Versorgung ermöglichen. Die Versorgungsleitung 19 kann als elektrischer Anschluss an die Antennenvorrichtung 10 nutzbar sein oder mit einem solchen Anschluss verbunden sein. Ein Impedanzsprung oder -wechsel zwischen der Versorgungsleitung 19 und dem Befestigungsbereich 16a kann einen Reflexionskoeffizienten der Antennenvorrichtung 10 zumindest beeinflussen. Bevorzugt weist die Versorgungsleitung 19 eine geringere Breite auf als der Befestigungsbereich 16a, so dass der Befestigungsbereich 16a gegenüber der Versorgungsleitung 19 niederohmig wirkt. Die Versorgungsleitung 19 kann auch an anderen Antennenvorrichtungen gemäß hierin beschriebenen Ausführungsbeispielen angeordnet sein.

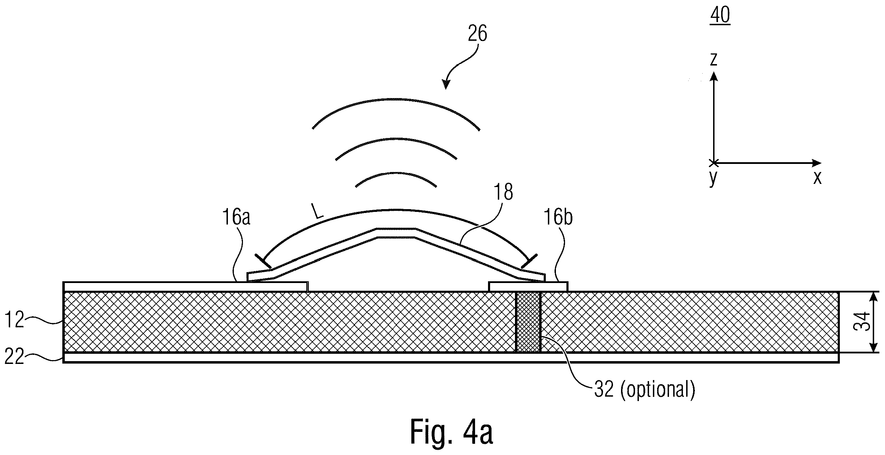

Fig. 4a zeigt eine schematische Seitenschnittansicht einer Antennenvorrichtung 40 gemäß einem weiteren Ausführungsbeispiel, bei der der Befestigungsbereich 16b und die Metallisierung 22 durch eine elektrisch leitfähige Struktur 32 verbunden sind. Das bedeutet, dass der Befestigungsbereich 16b und die Metallisierung 22 elektrisch über die elektrisch leitfähige Verbindung 32 miteinander verbunden sind. Bei der elektrisch leitfähigen Struktur 32 kann es sich beispielsweise um ein Via handeln. Die elektrisch leitfähige Struktur 32 kann sich durch das Substrat 12 bzw. durch das Substratmaterial hindurcherstrecken. Die Metallisierung 22 kann als Rückleitung, Referenzpotential oder Masseplatte eingesetzt werden. Der Wellenlängenbereich des Funksignals 26 kann von einer Ausdehnung oder Länge 34 der elektrisch leitfähigen Struktur 32 mit beeinflusst sein. Die Performanz der Antenne kann durch eine Leitfähigkeit bzw. einen Widerstandswert der elektrisch leitfähigen Struktur 32 sowie durch ihre geometrische Abmessungen beeinflusst sein.

Die Länge 34 kann sich beispielsweise entlang der z-Richtung durch das Substrat 12 oder durch ein Substratmaterial erstrecken. Wie es bereits ausgeführt wurde, kann der Wellenlängenbereich auch von einer Ausdehnung des Befestigungsbereichs 16a oder der Zuleitung zu dem Bändchen 18 beeinflusst sein, etwa entlang der x-Richtung. Das bedeutet, eine abgestrahlte Wellenlänge oder ein Wellenlängenbereich kann von der Summe der Ausdehnungen zumindest zweier Komponenten umfassend das Bändchen 18 und zumindest eines aus dem Befestigungsbereich 16a und der elektrisch leitfähigen Struktur 32 beeinflusst sein. Der Wellenlängenbereich kann auch von einer Ausdehnung des Befestigungsbereichs 16b entlang der z-Richtung beeinflusst sein.

In anderen Worten kann die Antennenvorrichtung 40 eine Streifenleitung als Befestigungsbereich 16a umfassen, und das Bändchen 18 kann über die elektrisch leitfähige Struktur 32 mit der Metallisierung 22 verbunden sein, die als Rückstrompfad des Bändchens 18 dient. Die Konfiguration der Antennenvorrichtung 40 kann als Quasi-Halbschleifen-RBA bezeichnet werden. Die Antennenvorrichtung 40 kann auch ohne die elektrisch leitfähige Struktur 32 ausgebildet sein, wobei die Rückführung des Stroms bzw. die Ankopplung der Antennenvorrichtung 40 an ein Referenzpotential durch eine Einkopplung durch das dielektrische Material des Substrats 12 erfolgen kann. In anderen Worten kann die elektrisch leitfähige Struktur 32 Teil der Antenne sein.

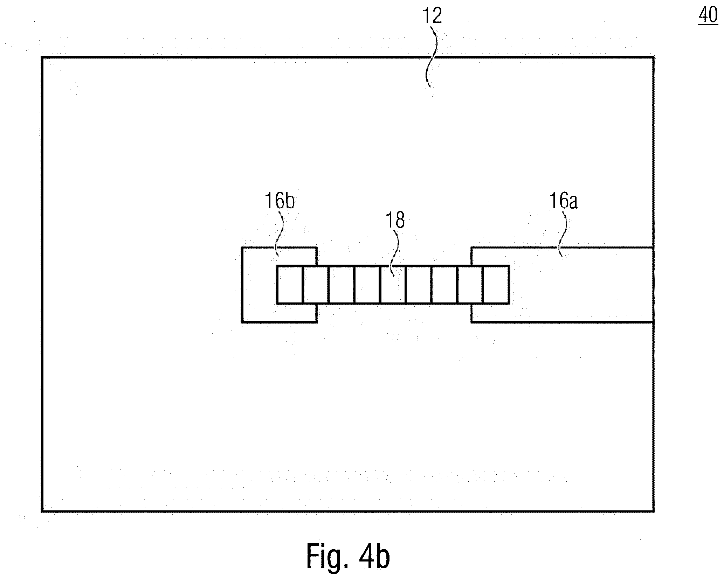

Fig. 4b zeigt eine schematische Aufsicht auf die Antennenvorrichtung 40, die in Abwesenheit der im Zusammenhang mit Fig. 4a beschriebenen elektrisch leitfähigen Struktur 32 ausgeführt ist.

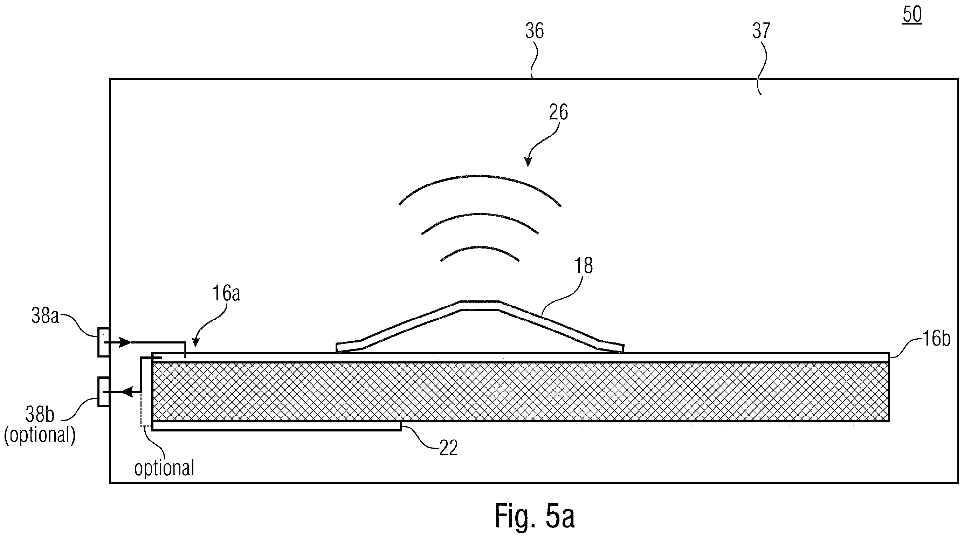

Fig. 5a zeigt eine schematische Seitenschnittansicht einer Antennenvorrichtung 50 gemäß einem Ausführungsbeispiel, die ein Gehäuse 36 aufweist. Das Gehäuse 36 ist zumindest bereichsweise umfassend ein dielektrisches oder elektrisch isolierendes Material gebildet, um einen Austritt des Funksignals 26 aus dem Gehäuse 36 zu ermöglichen. Beispielsweise kann das Gehäuse 36 ein Kunststoffmaterial oder ein Glasmaterial umfassen. Kunststoffmaterial kann während einer Vereinzelung und Verkapselung der Antennenvorrichtung 50 aus einem Wafer heraus angeordnet werden. Im Inneren des Gehäuses 36 kann die Antennenvorrichtung 10 angeordnet sein. Alternativ oder zusätzlich kann eine andere Antennenvorrichtung gemäß hierin beschriebenen Ausführungsformen, zumindest ein Antennenarray und/oder zumindest eine elektrische Schaltung gemäß hierin beschriebenen Ausführungsformen im Inneren des Gehäuses 36 angeordnet sein. Ein Innenvolumen 37 des Gehäuses 36 kann zumindest teilweise mit einem Gas, wie etwa Luft oder einem Material mit einer geringen Dielektrizitätskonstante oder zu einem geringen Leistungsverlust führendem Material gefüllt sein.

Das Gehäuse 36 umfasst einen Anschluss 38a, der mit dem Befestigungsbereich 16a verbunden ist. Der Anschluss 38a ist konfiguriert, um mit einem Signalausgang eines Hochfrequenz-Chips verbunden zu werden. Das bedeutet, dass über den Anschluss 38a beispielsweise das Hochfrequenzsignal 24 empfangen werden kann. Das Gehäuse 36 kann einen weiteren Anschluss 38b aufweisen, der mit dem Befestigungsbereich 16b oder mit der Metallisierung 22 verbunden ist. Beispielsweise ist der Anschluss 38b mit einer als Rückleitung konfigurierten elektrischen Leitung verbunden, die, wie es vorangehend beschrieben wurde, durch den Befestigungsbereich 16b implementiert sein kann oder durch die Metallisierung 22 implementiert sein kann.

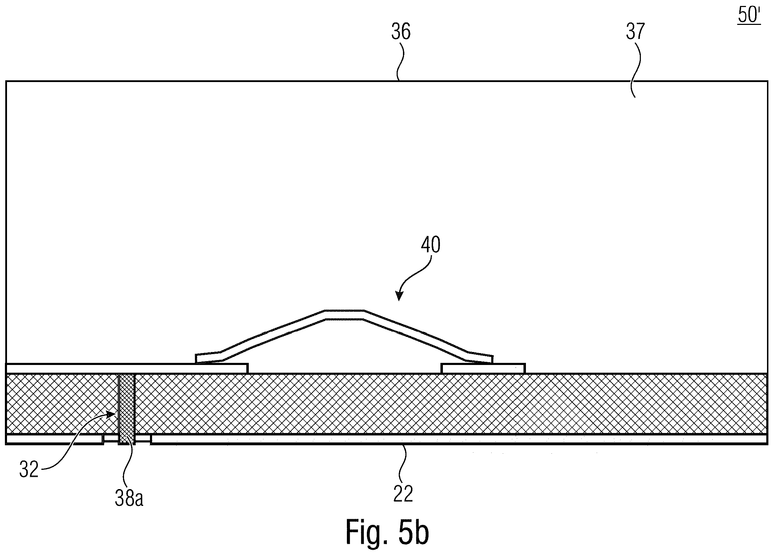

Fig. 5b zeigt eine schematische Seitenschnittansicht einer Antennenvorrichtung 50' gemäß einem Ausführungsbeispiel, die das Gehäuse 36 aufweist in dessen Inneren 37 bspw. die Antennenvorrichtung 40 angeordnet ist. Alternativ oder zusätzlich können andere Antennenvorrichtungen, Antennenarrays und/oder elektrische Schaltungen angeordnet werden. Die Metallisierung 22 kann mit einer Wand des Gehäuses verbunden ist oder die Wand bildet, um eine Kontaktierung der Metallisierung mit anderen Komponenten auf einfachem Wege zu ermöglichen. Der Anschluss 38a kann mit der elektrisch leitfähigen Struktur 32 verbunden sein, die bspw. als Via ausgeführt ist. Der Anschluss 38a kann zum Bereitstellen einer vertikalen Verbindung zu der Antennenvorrichtung 10 dienen, etwa an dem Befestigungsbereich 16a, um die Antennenvorrichtung 40 anzuregen. Somit kann der Anschluss 38a einen Kontakt zur Umgebung der Antennenvorrichtung 50' bereitstellen.

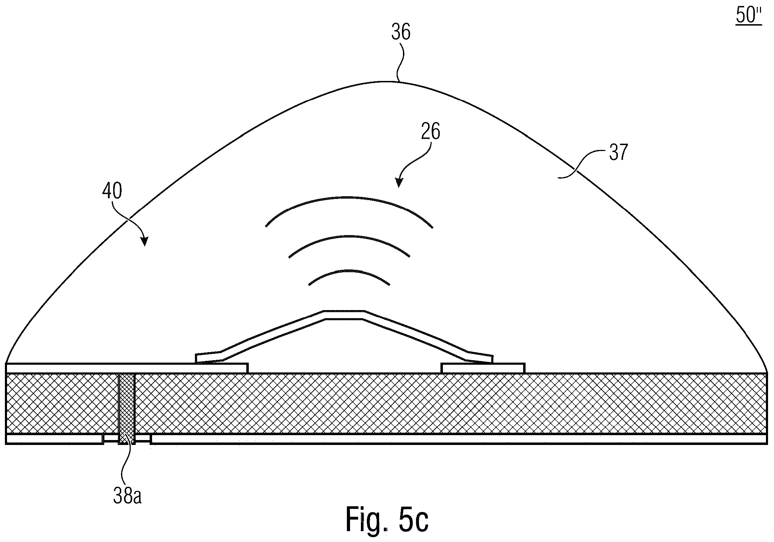

Fig. 5c zeigt eine schematische Seitenschnittansicht einer Antennenvorrichtung 50" gemäß einem Ausführungsbeispiel, bei der das Gehäuse 36 im Vergleich zu Fig. 5b als Linse ausgeführt ist, die ausgebildet ist, um eine Abstrahlcharakteristik des Funksignals 26 zu beeinflussen. Bspw. kann die Linse ausgebildet sein, um das Funksignal 26 zu bündeln. Bspw. kann das Innere 37 des Gehäuses 36 zumindest teilweise mit einem dielektrischen Material gefüllt sein und eine äußere Form des Gehäuses 36 eine konkave oder konvexe Form aufweisen, um eine streuende oder bündelnde Funktion der Linse zu erhalten. Das bedeutet, dass das Gehäuse eine Linse bilden kann, die ausgebildet ist, um ein von der Antennenvorrichtung erzeugtes Funksignal 26 zu bündeln oder zu streuen.

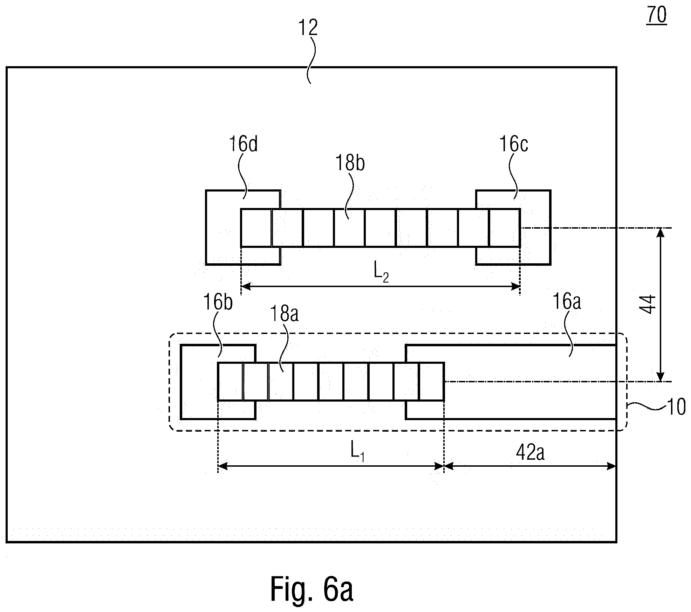

Fig. 6a zeigt eine schematische Aufsicht auf ein weiteres Antennenarray 70 gemäß einem Ausführungsbeispiel. Das Antennenarray 70 umfasst die Antennenvorrichtung 10, bei der der Befestigungsbereich gleichzeitig als Versorgungsleitung nutzbar ist. Das Antennenarray 70 umfasst und das Bändchen 18b, das zwei Befestigungsbereiche 16c und 16d miteinander verbindet. Die Befestigungsbereiche 16c und 16d und das Bändchen 18b sind elektrisch oder galvanisch von dem Bändchen 18a der Antennenvorrichtung 10 des Antennenarrays 70 getrennt. Alternativ oder zusätzlich zur Antennenvorrichtung 10 kann das Antennenarray 70 die Antennenvorrichtung 20, 30, 40 und/oder 50 umfassen. Das Bändchen 18b kann eine Länge L₂ aufweisen, die von der Länge L₁ und/oder von einer Summe der Längen L₁ und der Ausdehnung 42a des Befestigungsbereichs 16a verschieden ist. Ferner kann das Bändchen 18b mit einem Abstand 44 und in etwa parallel zu dem Bändchen 18a angeordnet sein. Dies ermöglicht eine Wirkung des Bändchens 18b als Direktor oder Reflektor, wie es beispielsweise von sogenannten Yagi-Uda-Konfigurationen bekannt ist, die ein Driver-Element zur Erzeugung des Funksignals sowie zumindest ein Reflektorelement und zumindest ein Direktorelement umfassen. Das bedeutet, dass Bändchen 18b kann als Reflektor-Antenne oder als Direktor-Antenne wirken, indem es mit zumindest einem der Bändchen der Antennenvorrichtung 10 in Wechselwirkung tritt. Alternativ hierzu kann das Bändchen 18b auch in einer anderen Konfiguration als passiver Strahler angeordnet sein, wobei der Abstand 44, die Länge L₂ und/oder eine Orientierung des Bändchens 18b bezüglich des Bändchens 18a variierbar sind. Alternativ oder zusätzlich kann das Bändchen 18b Teil einer Antennenvorrichtung sein, die zumindest ein Bändchen umfasst. So kann das Bändchen 18b Teil einer weiteren Bändchenbondantenne sein, etwa der Antennenvorrichtung 10 umfassend ein oder mehr Bändchen. Alternativ oder zusätzlich kann das Bändchen 18b Teil einer anderen Antennenvorrichtung sein. Es kann auch eine höhere Anzahl von Antennenvorrichtungen in dem Array angeordnet sein, wobei die Antennenvorrichtungen in gleicher oder von einander verschiedener Weise gebildet sein können.

Das Bändchen der Antennenvorrichtung des Arrays 70 kann mittels eines weiteren Bändchens verlängert werden.

Somit können mit einer erfindungsgemäßen Antennenvorrichtung nahezu beliebige Antennenarrays bereitgestellt werden. Beispielsweise können mit der erfindungsgemäßen Antennenvorrichtung in Kombination mit zumindest einem, wie zuvor beschriebenen, weiteren elektrischen Leiter in Form eines Bändchens diverse Antennenarray-Strukturen bereitgestellt werden.

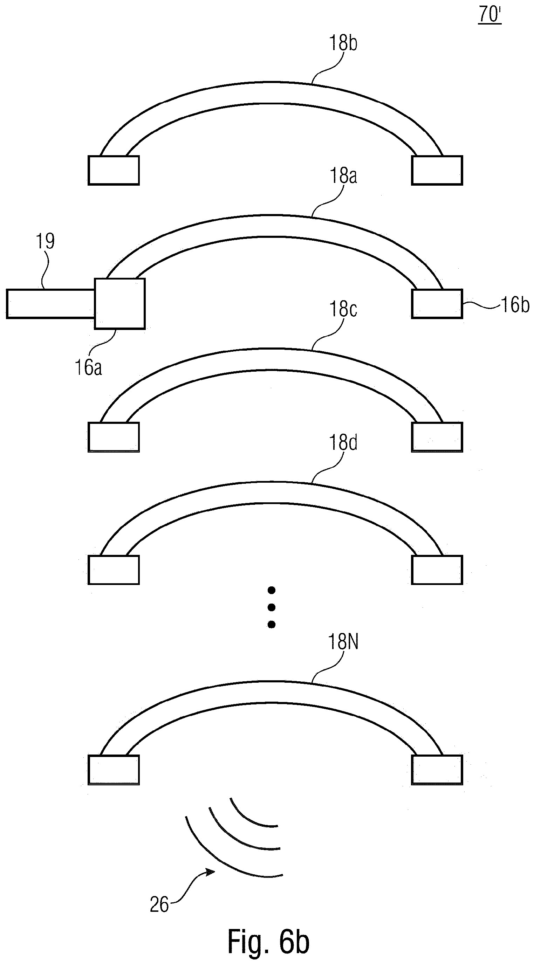

Fig. 6b zeigt eine schematische Aufsicht auf ein Antennenarray 70' gemäß einem Ausführungsbeispiel, das als Yagi-Uda-Antenne ausgeführt ist. Das über die Versorgung 19 gespeiste Bändchen 18a ist ausgebildet, um das Funksignal 26 zu erzeugen. Das Bändchen 18b ist als Reflektorelement ausgebildet. Ferner ist eine beliebige Anzahl Bändchen 18c, 18d bis 18N jeweils als Direktorelement ausgebildet. Die Antennenvorrichtung 70' ist ausgebildet, um das Funksignal 26 entlang der Anordnung der Direktorelemente 18c, 18d bis 18N abzustrahlen, das bedeutet, es kann eine Richtwirkung erhalten werden. Eine Anzahl der Direktorelemente kann beliebig sein. Die Antennenvorrichtung 70' kann zumindest ein Direktorelement, zumindest zwei Direktorelemente, zumindest drei Direktorelemente oder eine höhere Anzahl, etwa zumindest fünf umfassen.

Obwohl das Antennenarray 70' so dargestellt ist, dass die Reflektor- und Direktorelemente jeweils ein Bändchen 18b bis 18N umfassen, kann jedes dieser Elemente unabhängig von einander umfassend eine Serienschaltung von Bändchen gebildet sein.

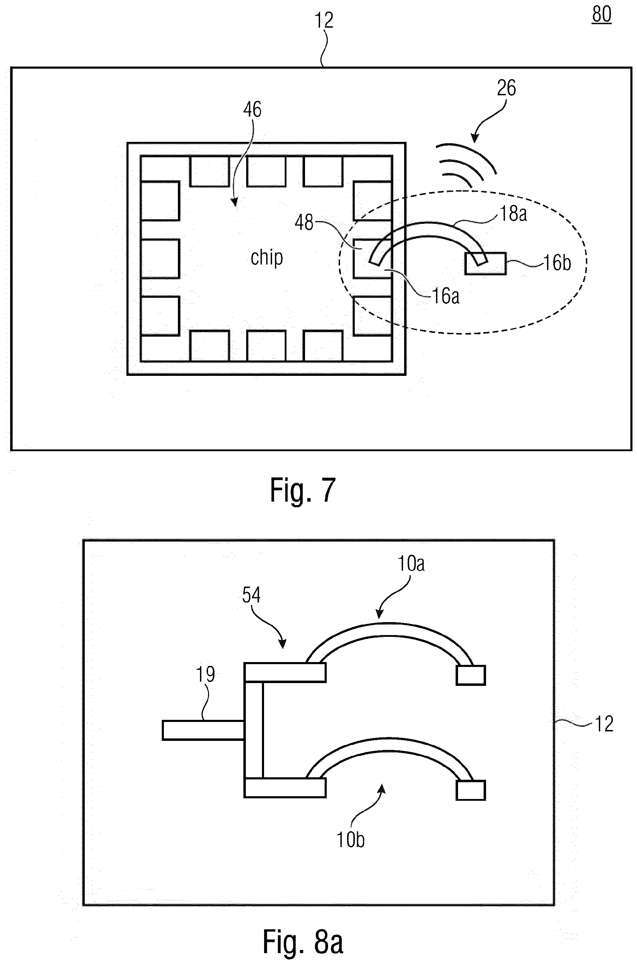

Fig. 7 zeigt eine schematische Aufsicht auf eine elektrische Schaltung 80 gemäß einem Ausführungsbeispiel. Die elektrische Schaltung 80 umfasst die Antennenvorrichtung 10. Alternativ oder zusätzlich kann die Antennenvorrichtung 20, 30, 40 und/oder 50 oder zumindest eines der Antennenarrays 70 oder 70' angeordnet sein. Die elektrische Schaltung 80 umfasst ferner einen Hochfrequenz-Chip 46, der ausgebildet ist, um ein Hochfrequenzsignal an einem Signalausgang oder Antennenport 48 bereitzustellen. Bei dem Signalausgang 48 kann es sich beispielsweise um einen Befestigungsbereich oder einen Pin des Hochfrequenz-Chips 46 handeln. Bei dem Hochfrequenzsignal kann es sich beispielsweise um das elektrische Signal 24 handeln. Die Antennenvorrichtung 10 kann mit dem Hochfrequenz-Chip 46 auf demselben Substrat 12 angeordnet sein. Der Befestigungsbereich 16a kann über das Bändchen 18a das zwischen dem Signalausgang 48 und dem Befestigungsbereich 16b angeordnet ist, verbunden sein, so dass die Antennenvorrichtung 10 das Funksignal 26 ansprechend auf das von dem Signalausgang 48 erhaltenen Signal bereitstellt.

Der Befestigungsbereich 16a kann der Signalausgang 48 sein, der auf dem Chip angeordnet ist.

Alternativ oder zusätzlich kann eine elektrische Verbindung auch zwischen dem Signalausgang 48 und einem Anschluss eines Gehäuses der Antennenvorrichtung angeordnet sein, etwa zwischen dem Signalausgang 48 und dem Anschluss 38a.

Der Hochfrequenz-Chip 46 kann auf dem Substrat 12 angeordnet sein, etwa mittels Bonding, oder kann auch in das Substrat 12 integriert sein, das bedeutet, Teil des Substrats 12 sein. In anderen Worten kann der Hochfrequenz-Chip 46 auf der selben Ebene angeordnet sein, wie das Substrat 12 oder kann auf dem Substrat 12 montiert sein. In der Ausführungsform der elektrischen Schaltung 80 bildet das Bändchen 18 das den Hochfrequenz-Chip 46 und das Substrat 12 verbindet eine Antenne. Auf einer zweiten Lage des Substrates, etwa einer Rückseite oder einer eingebetteten Schicht kann eine Metallisierung angeordnet sein, die als Rückstrompfad dient, etwa die Metallisierung 22.

Das Antennenarray 80 kann ein weiteres Bändchen umfassen, das den Befestigungsbereich 16b und einen weiteren Befestigungsbereich miteinander elektrisch verbindet. Das bedeutet, dass der Befestigungsbereich 16a und der weitere Befestigungsbereich über das Bändchen 18a, den Befestigungsbereich 16b und das weitere Bändchen elektrisch miteinander verbunden sein können. Die Leiterbänder können somit seriell miteinander verbunden sein. Die Befestigungsbereiche können auf dem gemeinsamen Substrat 12 angeordnet sein. Alternativ hierzu kann das Substrat 12 auch mehrstückig ausgeführt sein, so dass zumindest einer der Befestigungsbereiche auf einem anderen Substrat angeordnet ist als die verbleibenden Befestigungsbereiche.

Ein Wellenlängenbereich des Funksignals kann aus einer Summe der so erhaltenen Serienschaltung der Bändchen sowie unter Berücksichtigung der Ausdehnungen, das heißt Längen, der Befestigungsbereiche beeinflusst sein. Das bedeutet, dass eine Länge des Befestigungsbereichs 16a von einem Einspeisepunkt hin zu dem Bändchen 18a, eine Länge des Bändchens 18a sowie eine Distanz auf dem Befestigungsbereich 16b zwischen den Leiterbändern und eine Länge des weiteren Bändchens ggf. zusammen mit anderen Strukturen, etwa Vias, die Wellenlänge oder Resonanzlänge des Funksignals beeinflussen. Die Länge auf den Befestigungsbereichen kann beispielsweise gering oder nahe null sein, so dass der Einfluss des Abstandes vernachlässigbar wird.

Fig. 8a zeigt ein schematisches Blockschaltbild eines Antennenarray 90 gemäß einem Ausführungsbeispiel, das eine erste Antennenvorrichtung 10a und eine zweite Antennenvorrichtung 10b umfasst, die parallel zueinander geschaltet sind. Die Antennenvorrichtungen 10a und 10b können gemeinsam über die Versorgung 19 versorgt werden, wobei die Antennenvorrichtungen 10a und 10b über einen Spannungs- oder Leistungsteiler 54 parallel miteinander verschaltet und mit der Versorgung 19 verbunden sind. Dies ermöglicht eine identische Ansteuerung der Antennenvorrichtungen 10a und 10b. Die gemeinsame Versorgung der Antennenvorrichtungen 10a und 10b stellt eine weitere Form der wechselseitigen Wechselwirkung zwischen den Antennenvorrichtungen dar. Verglichen mit dem Array 70 oder 70' kann eines der Bändchen der Antennenvorrichtung 10a bzw. 10b Teil einer zweiten oder weiteren Antennenvorrichtung sein. Die Antennenvorrichtungen können über den Leistungsteiler 42 galvanisch verbunden sein.

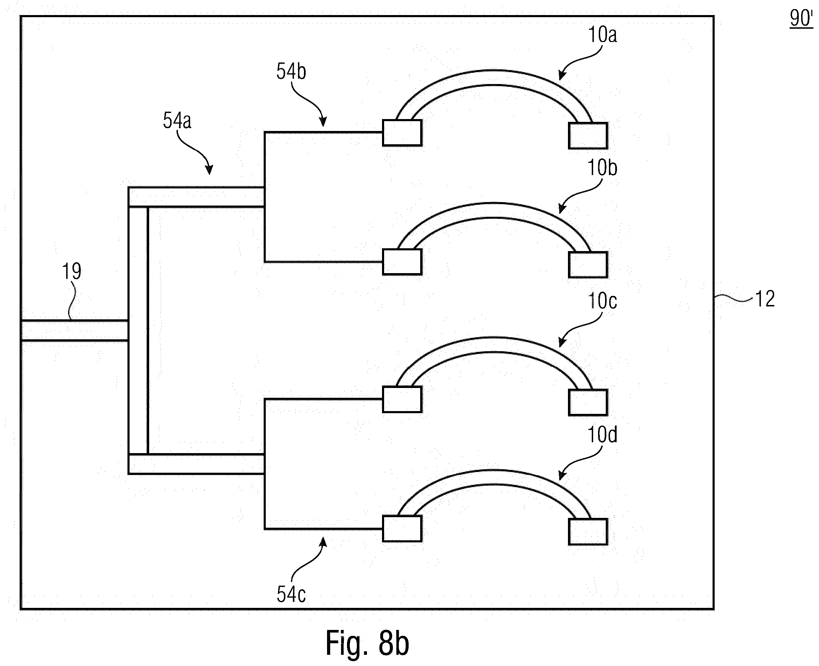

Fig. 8b zeigt eine schematische Ansicht eines Antennenarrays 90' gemäß einem Ausführungsbeispiel, das vier Antennenvorrichtungen 10a, 10b, 10c und 10d umfasst, die über ein Netzwerk von Spannungs- oder Leistungsteilern 54a, 54b und 54c mit der Versorgung 19 verbunden sind. Beispielsweise kann jeweils ein Schenkel eines ersten Leistungsteilers 54a mit einem weiteren Leistungsteiler 54b bzw. 54c verbunden sein. Ein jeweiliger weiterer Schenkel kann mit weiteren Leistungsteilern oder mit einer der Antennenvorrichtung 10a-10d verbunden sein, so dass insgesamt eine Anzahl von 2^{N} Antennenvorrichtungen versorgbar ist, wobei N einer Anzahl der Stufen des Netzwerks von Leistungsteilern entspricht.

Obwohl die Antennenarrays 90 und 90' so beschreiben wurden, dass sie eine Mehr- oder Vielzahl von Antennenvorrichtungen 10 umfassen, können die Arrays 90oder 90' unabhängig von einander auch andere Antennenvorrichtungen umfassen, etwa Antennenvorrichtungen 20, 30, 40 und/oder 50, d. h. auch Kombinationen unterschiedlicher Antennenvorrichtungen können in den Arrays 90 oder 90' angeordnet sein.

Die gezeigten Konfigurationen der Antennenvorrichtungen, der Antennenarrays und der elektrischen Schaltung sind lediglich beispielhaft. Durch die beschriebene Nutzung von Leiterbändern als Antennenelemente kann eine beliebige Antennenkonfiguration, etwa eine Monopolantenne, eine Dipolantenne oder ein Array von Antennen gebildet werden, ebenso wie Schleifenantennen.

Obwohl manche Aspekte im Zusammenhang mit einer Vorrichtung beschrieben wurden, versteht es sich, dass diese Aspekte auch eine Beschreibung des entsprechenden Verfahrens darstellen, sodass ein Block oder ein Bauelement einer Vorrichtung auch als ein entsprechender Verfahrensschritt oder als ein Merkmal eines Verfahrensschrittes zu verstehen ist. Analog dazu stellen Aspekte, die im Zusammenhang mit einem oder als ein Verfahrensschritt beschrieben wurden, auch eine Beschreibung eines entsprechenden Blocks oder Details oder Merkmals einer entsprechenden Vorrichtung dar.

Die oben beschriebenen Ausführungsbeispiele stellen lediglich eine Veranschaulichung der Prinzipien der vorliegenden Erfindung dar. Es versteht sich, dass Modifikationen und Variationen der hierin beschriebenen Anordnungen und Einzelheiten anderen Fachleuten einleuchten werden. Deshalb ist beabsichtigt, dass die Erfindung lediglich durch den Schutzumfang der nachstehenden Patentansprüche und nicht durch die spezifischen Einzelheiten, die anhand der Beschreibung und der Erläuterung der Ausführungsbeispiele hierin präsentiert wurden, beschränkt sei.

## Patentansprüche

1. Antennenvorrichtung (10; 20; 30; 40; 50) umfassend:
ein Substrat (12), das eine erste Hauptseite (14a) und eine gegenüberliegend angeordnete zweite Hauptseite (14b) aufweist;
einen ersten und einen zweiten an der ersten Hauptseite (14a) angeordneten Befestigungsbereich;
ein den ersten Befestigungsbereich (16a) und den zweiten Befestigungsbereich (16b) verbindendes Bändchen (18), das zumindest bereichsweise von dem Substrat (12) beabstandet ist; **gekennzeichnet durch**
eine an der zweiten Hauptseite (14b) angeordnete Metallisierung (22), die gegenüberliegend zumindest einem aus dem ersten Befestigungsbereich (16a), dem zweiten Befestigungsbereich (16b) und dem Bändchen (18) angeordnet ist; und
dass der erste Befestigungsbereich (16a) als Streifenleitung zum Erhalten eines elektrischen Signals (24) ausgeführt ist, wobei die Antennenvorrichtung ausgebildet ist, um basierend auf dem elektrischen Signal (24) ein Funksignal (26) mit dem Bändchen (18) auszusenden, wobei ein Wellenlängenbereich des mit dem Bändchen (18) und der Streifenleitung ausgesendeten Funksignals (26) durch eine Summe einer Länge (L₁) des Bändchens (18) und einer Länge (42a) der Streifenleitung beeinflusst ist.

2. Antennenvorrichtung gemäß Anspruch 1, bei der die an der zweiten Hauptseite (14b) angeordnete Metallisierung (22) über die zweite Hauptseite (14b) hinweg unterbrochen ausgeführt ist.

3. Antennenvorrichtung gemäß einem der vorangehenden Ansprüche, bei der die an der zweiten Hauptseite (14b) angeordnete Metallisierung (22) gegenüberliegend dem ersten Befestigungsbereich (16a), dem zweiten Befestigungsbereich (16b) und dem Bändchen (18) angeordnet ist.

4. Antennenvorrichtung gemäß einem der vorangehenden Ansprüche, bei dem die an der zweiten Hauptseite (14b) angeordnete Metallisierung (22) ein Reflektor für ein durch das Bändchen (18) ausgesendetes Funksignal (26) ist.

5. Antennenvorrichtung gemäß einem der vorangehenden Ansprüche, bei der der zweite Befestigungsbereich (16b) und die an der zweiten Hauptseite (14b) angeordnete Metallisierung (22) durch eine elektrisch leitfähige Struktur (32) durch das Substrat (12) hindurch verbunden sind.

6. Antennenvorrichtung gemäß Anspruch 5, wobei ein Wellenlängenbereich eines mit dem Bändchen (18) und der leitfähigen Struktur (32) ausgesendeten Funksignals (26) durch eine Summe einer Länge (L₁) des Bändchens (18) und einer Länge (34) der leitfähigen Struktur (32) beeinflusst ist.

7. Antennenvorrichtung gemäß einem der vorangehenden Ansprüche, bei der der zweite Befestigungsbereich (16b) den ersten Befestigungsbereich (16a) zumindest teilweise umschließt, so dass der erste Befestigungsbereich (16a) bezüglich des zweiten Befestigungsbereichs (16b) als coplanare Versorgungsleitung wirkt.

8. Vorrichtung, die ein Gehäuse (36) und eine Antennenvorrichtung gemäß einem der vorangehenden Ansprüche umfasst, wobei die Antennenvorrichtung in dem Gehäuse (36) angeordnet ist, und wobei das Gehäuse (36) einen Anschluss (38a) zum Verbinden der Antennenvorrichtung mit einem Hochfrequenz-Chip (46) aufweist.

9. Vorrichtung gemäß Anspruch 8, wobei das Gehäuse (36) eine Linse bildet, die ausgebildet ist, um ein von der Antennenvorrichtung erzeugtes Funksignal (26) zu bündeln oder zu streuen.

10. Antennenvorrichtung oder Vorrichtung gemäß einem der vorangehenden Ansprüche, die einen Anschluss zur vertikalen Speisung oder zur horizontalen Speisung umfasst und ausgebildet ist, um basierend auf einem über den Anschluss empfangenen elektrischen Signal (24) ein Funksignal (26) bereitzustellen.

11. Antennenarray (70; 70', 90; 90') mit zumindest einer Antennenvorrichtung oder Vorrichtung gemäß einem der vorangehenden Ansprüche, bei der das Bändchen ein erstes Bändchen (18a) ist, wobei das Antennenarray zumindest ein zweites Bändchen (18b) aufweist, das mit dem ersten Bändchen (18a) in Wechselwirkung steht.

12. Antennenarray gemäß Anspruch 11, wobei das erste (18a) und das zweite Bändchen (18b) elektrisch seriell miteinander verbunden sind, so dass ein Wellenlängenbereich eines mit dem Antennenarray ausgesendeten Funksignals (26) durch eine Summe einer Länge (Li) des ersten Bändchens (18a) und einer Länge (L₂) des zweiten Bändchens (18b) beeinflusst ist.

13. Antennenarray gemäß Anspruch 11, bei der das erste (18a) und das zweite Bändchen (18b) galvanisch voneinander getrennt sind und so zueinander angeordnet sind, dass das zweite Bändchen (18b) bezüglich des ersten Bändchens (18) als Reflektor-Antenne oder als Direktor-Antenne wirkt.

14. Antennenarray gemäß einem der Ansprüche 11 bis 13, bei dem die Antennenvorrichtung oder Vorrichtung eine erste Antennenvorrichtung oder Vorrichtung ist und das eine bei dem das zweite Bändcher (18b) Teil einer zweiten Antennenvorrichtung ist, wobei die erste Antennenvorrichtung oder Vorrichtung und die zweite Antennenvorrichtung oder Vorrichtung über einen Leistungsteiler (42; 42a-b) verbunder sind.

15. Elektrische Schaltung (80) umfassend:
eine Antennenvorrichtung (10; 20; 30; 40; 50) oder Vorrichtung gemäß einem der Ansprüche 1 bis 10;
einen Hochfrequenz-Chip (46), der ausgebildet ist, um ein Hochfrequenzsignal (24) an einem Signalausgang (48) bereitzustellen und der auf dem Substrat (12) der Antennenvorrichtung angeordnet ist;
wobei der erste Befestigungsbereich (16a) mit dem Signalausgang (48) elektrisch verbunden (52) ist oder wobei der Signalausgang (48) der erste Befestigungsbereich (16a) ist.

16. Elektrische Schaltung gemäß Anspruch 15, bei der der erste Befestigungsbereich (16a) durch einen Bonddraht oder ein Bändchen mit dem Signalausgang (48) verbunden ist.

## Claims

1. Antenna apparatus (10; 20; 30; 40; 50) including:
a substrate (12) comprising a first main side (14a) and a second main side (14b) arranged opposite thereto;
first and second fixing regions arranged on the first main side (14a);
a ribbon (18) which connects the first fixing region (16a) and the second fixing region (16b) and is spaced apart from the substrate (12) at least in some regions; **characterized in that**
a metallization (22) arranged on the second main side (14b) is arranged opposite to at least one of the first fixing region (16a), the second fixing region (16b), and the ribbon (18); and
the first fixing region (16a) is configured as a strip line for obtaining an electric signal (24), the antenna apparatus being configured to emit a radio signal (26) with the ribbon (18) on the basis of the electric signal (24), wherein a wavelength range of the radio signal (26) emitted with the ribbon (18) and the strip line is influenced by a sum of a length (L1) of the ribbon (18) and of a length (42a) of the strip line.

2. Antenna apparatus as claimed in claim 1, wherein the metallization (22) arranged on the second main side (14b) is discontinuously implemented across the second main side (14b).

3. Antenna apparatus as claimed in any of the preceding claims, wherein the metallization (22) arranged on the second main side (14b) is arranged opposite to the first fixing region (16a), the second fixing region (16b), and the ribbon (18).

4. Antenna apparatus as claimed in any of the preceding claims, wherein the metallization (22) arranged on the second main side (14b) is a reflector for a radio signal (26) emitted by the ribbon (18).

5. Antenna apparatus as claimed in any of the preceding claims, wherein the second fixing region (16b) and the metallization (22) arranged on the second main side (14b) are connected through the substrate (12) via an electrically conductive structure (32).

6. Antenna apparatus as claimed in claim 5, wherein a wavelength range of a radio signal (26) emitted with the ribbon (18) and the conductive structure (32) is influenced by a sum of a length (Li) of the ribbon (18) and of a length (34) of the conductive structure (32).

7. Antenna apparatus as claimed in any of the preceding claims, wherein the second fixing region (16b) at least partially encloses the first fixing region (16a) so that the first fixing region (16a) acts as a coplanar supply line with respect to the second fixing region (16b).

8. Apparatus including a housing (36) and an antenna apparatus as claimed in any of the preceding claims, the antenna apparatus being arranged within the housing (36), the housing (36) comprising a terminal (38a) for connecting the antenna apparatus to a radio-frequency chip (46).

9. Apparatus as claimed in claim 8, wherein the housing (36) forms a lens configured to concentrate or diffuse a radio signal (26) generated by the antenna apparatus.

10. Antenna apparatus or apparatus as claimed in any of the preceding claims, including a terminal for vertical feeding or for horizontal feeding, and configured to provide a radio signal (26) on the basis of an electric signal (24) received via the terminal.

11. Antenna array (70; 70', 90; 90') comprising at least one antenna apparatus as claimed in any of the preceding claims, wherein the ribbon is a first ribbon (18a), the antenna array comprising at least one second ribbon (18b) interacting with the first ribbon (18a).

12. Antenna array () as claimed in claim 11, wherein the first (18a) and the second ribbon (18b) are electrically connected in series so that a wavelength range of a radio signal (26) emitted with the antenna array is influenced by a sum of a length (Li) of the first ribbon (18a) and of a length (L₂) of the second ribbon (18b).

13. Antenna array as claimed in claim 11, wherein the first (18a) and the second ribbon (18b) are galvanically separated from each other and are arranged with respect to each other such that the second ribbon (18b) acts as a reflector antenna or as a director antenna with respect to the first ribbon (18).

14. Antenna array as claimed in any of claims 11 to 13, wherein the antenna apparatus or apparatus is a first antenna apparatus or apparatus and the one in which the second ribbon (18b) is part of a second antenna apparatus, the first antenna apparatus or apparatus and the second antenna apparatus or apparatus being connected via a power divider (42; 42a-b).

15. Electric circuit (80), including:
an antenna apparatus (10; 20; 30; 40; 50) or apparatus as claimed in any of claims 1 to 10;
a radio-frequency chip (46) configured to provide a radio-frequency signal (24) at a signal output (48), and arranged on the substrate (12) of the antenna apparatus;
wherein the first fixing region (16a) is electrically connected (52) to the signal output (48) or wherein the signal output (48) is the first fixing region (16a).

16. Electric circuit as claimed in claim 15, wherein the first fixing region (16a) is connected to the signal output (48) through a bond wire or a ribbon.

## Revendications

1. Dispositif d'antenne (10; 20; 30; 40; 50), comportant:
un substrat (12) qui présente une première face principale (14a) et une deuxième face principale (14b) disposée de manière opposée;
une première et une deuxième zone de fixation disposées sur la première face principale (14a);
un ruban (18) connectant la première zone de fixation (16a) et la deuxième zone de fixation (16b), qui est distant au moins par zones du substrat (12);
**caractérisé par**
une métallisation (22) disposée sur la deuxième face principale (14b), qui est disposée en regard d'au moins l'un parmi la première zone de fixation (16a), la deuxième zone de fixation (16b) et le ruban (18); et
le fait que la première zone de fixation (16a) est réalisée sous forme d'une ligne en ruban destinée à recevoir un signal électrique (24), où le dispositif d'antenne est conçu pour émettre, sur base du signal électrique (24), un signal radio (26) par le ruban (18), où une plage de longueurs d'onde du signal radio (26) émis par le ruban (18) et la ligne en ruban est influencée par une somme d'une longueur (Li) du ruban (18) et d'une longueur (42a) de la ligne en ruban.

2. Dispositif d'antenne selon la revendication 1, dans lequel la métallisation (22) disposée sur la deuxième face principale (14b) est réalisée de manière interrompue au-delà de la deuxième face principale (14b).

3. Dispositif d'antenne selon l'une des revendications précédentes, dans lequel la métallisation (22) disposée sur la deuxième face principale (14b) est disposée en regard de la première zone de fixation (16a), de la deuxième zone de fixation (16b) et du ruban (18).

4. Dispositif d'antenne selon l'une des revendications précédentes, dans lequel la métallisation (22) disposée sur la deuxième face principale (14b) est un réflecteur pour le signal radio (26) émis par le ruban (18).

5. Dispositif d'antenne selon l'une quelconque des revendications précédentes, dans lequel la deuxième partie de fixation (16b) et la métallisation (22) disposée sur la deuxième face principale (14b) sont connectées par une structure électriquement conductrice (32) à travers le substrat (12).

6. Dispositif d'antenne selon la revendication 5, dans lequel une plage de longueurs d'onde d'un signal radio (26) émis par le ruban (18) et la structure conductrice (32) est influencée par la somme d'une longueur (Li) du ruban (18) et d'une longueur (34) de la structure conductrice (32).

7. Dispositif d'antenne selon l'une des revendications précédentes, dans lequel la deuxième zone de fixation (16b) entoure au moins partiellement la première zone de fixation (16a), de sorte que la première zone de fixation (16a) agisse comme une ligne d'alimentation située dans le même plan par rapport à la deuxième zone de fixation (16b).

8. Dispositif comportant un boîtier (36) et un dispositif d'antenne selon l'une des revendications précédentes, dans lequel le dispositif d'antenne est disposé dans le boîtier (36), et dans lequel le boîtier (36) présente un raccord (38a) pour connecter le dispositif d'antenne à une puce à haute fréquence (46).

9. Dispositif selon la revendication 8, dans lequel le boîtier (36) forme une lentille qui est conçue pour concentrer ou disperser un signal radio (26) généré par le dispositif d'antenne.

10. Dispositif d'antenne ou dispositif selon l'une des revendications précédentes, qui comporte une connexion pour l'alimentation verticale ou pour l'alimentation horizontale et qui est conçu pour fournir, sur base d'un signal électrique reçu via la connexion (24), un signal radio (26).

11. Réseau d'antennes (70; 70', 90; 90') avec au moins un dispositif d'antenne ou un dispositif selon l'une des revendications précédentes, dans lequel le ruban est un premier ruban (18a), dans lequel le réseau d'antennes présente au moins un deuxième ruban (18b) qui est en interaction avec le premier ruban (18a).

12. Réseau d'antennes selon la revendication 11, dans lequel le premier (18a) et le deuxième ruban (18b) sont connectés électriquement en série l'un à l'autre, de sorte qu'une plage de longueurs d'onde d'un signal radio (26) transmis par le réseau d'antennes soit influencée par une somme d'une longueur (Li) du premier ruban (18a) et d'une longueur (L₂) du deuxième ruban (18b).

13. Réseau d'antennes selon la revendication 11, dans lequel le premier (18a) et le deuxième ruban (18b) sont séparés de manière galvanique l'un de l'autre et sont disposés l'un par rapport à l'autre de sorte que le deuxième ruban (18b) agisse, par rapport au premier ruban (18), comme une antenne à réflecteur ou comme une antenne directrice.

14. Réseau d'antennes selon l'une quelconque des revendications 11 à 13, dans lequel le dispositif d'antenne ou le dispositif est un premier dispositif d'antenne ou dispositif et l'un où le deuxième ruban (18b) fait partie d'un deuxième dispositif d'antenne, dans lequel le premier dispositif d'antenne ou dispositif et le deuxième dispositif d'antenne ou dispositif sont connectés par l'intermédiaire d'un diviseur de puissance (42; 42a-b).

15. Circuit électrique (80), comportant:
un dispositif d'antenne (10; 20; 30; 40; 50) ou dispositif selon l'une quelconque des revendications 1 à 10;
une puce à haute fréquence (46) qui est conçue pour fournir un signal à haute fréquence (24) à une sortie de signal (48) et qui est disposée sur le substrat (12) du dispositif d'antenne;
dans lequel la première zone de fixation (16a) est connectée électriquement (52) à la sortie de signal (48) ou dans lequel la sortie de signal (48) est la première zone de fixation (16a).

16. Circuit électrique selon la revendication 15, dans lequel la première zone de fixation (16a) est connectée à la sortie signal (48) par un fil de connexion ou un ruban.
